# EUROPEAN PATENT APPLICATION

(11) **EP 1 225 453 A2**
(43) Date of publication of application: **24.07.2002**
(21) Application number: 01204973.0
(22) Date of filing: 18.12.2001
(51) Int. Cl.: G01R 33/06

(54) **Magnetic field sensor with tailored magnetic response**

(30) Priority: 18.01.2001 US 764935
(71) Applicant: Delphi Technologies, Inc., Troy Michigan 48007 (US)
(72) Inventor: Schroeder, Thaddeus, Rochester Hills, MI 48309 (US); Partin, Dale Lee, Ray Township, MI 48096 (US); Heremans, Joseph Pierre, Troy, MI 48084 (US)
(74) Representative: Denton, Michael John

(57) **Abstract**

A circuit and method of providing desired response from magnetic field sensors (12, 14) to a predetermined magnetic function. Typically, magnetic field sensors, such as magnetoresistive devices and Hall effect sensors, provide an output which is a characteristic function of the magnetic field density, and so they do not generate a linear response in relation to any predetermined magnetic function, such as is required within numerous position or angle resolving circuits. The present invention utilizes two or more magnetically sensitive devices (12, 14) to tailor the overall sensor output signal to any desired function of the magnetic field density. The devices are connected in such a way that they mutually effect each other's voltages or currents to render the final desired output characteristic.

## Description

### 1. Field of the Invention

The present invention pertains generally to magnetic field sensors and more specifically to circuits and methods for generating a response according to a predetermined function of magnetic field density.

### 2. Description of the Background Art

Magnetic sensors are increasingly being utilized within electronic systems for the detection and measurement of parameters such as speed, position, and angle. Although a number of magnetic sensor types exist, the predominant forms are Hall effect sensors and magnetoresistive sensors. Often the output from a sensor is not in accord with the desired function of magnetic field density, because the output of a Hall effect sensor is a substantially linear response to the magnetic field density. For instance, employing a Hall effect sensor in a system to measure angular displacement results in an output which is decidedly non-linear in relation to the measured angle. Typically, the correction of these non-linearities in relation to the predetermined function requires the addition of circuitry to linearize the output, whereupon additional error, complication and expense arise.

Therefore, a need exists for a circuit and method that can provide linear sensing of magnetic fields according to any desired function of magnetic field density. The present invention satisfies those needs, as well as others, and overcomes the deficiencies of previously developed linearizing methods.

### BRIEF SUMMARY OF THE INVENTION

The invention generally comprises a circuit and method of magnetic sensing according to a predetermined function of magnetic field density. Multiple magnetic field sensors are combined in a single magnetic sense circuit to provide a tailored response according to the desired function of magnetic field density. The magnetic field sensors are chosen based on output characteristics and combined in configurations so as to provide offsetting sensor errors that essentially cancel out the errors within one another so as to provide a linear response to the predetermined function of magnetic field density.

An object of the invention is to provide a magnetic sensor circuit which is capable of providing a linear output in response to a predetermined function of magnetic field density, such as a function of angle, or position.

Another object of the invention is to provide a linear response to a predetermined function without the need of post measurement linearity correction. Another object of the invention is to provide a method of generating a linear response to a predetermined function of magnetic field density that is not dependent on a single type of magnetic sensing element.

Another object of the invention is to provide a method of generating a linear response to a predetermined function of magnetic field density that is inexpensive to implement.

Further objects and advantages of the invention will be brought out in the following portions of the specification, wherein the detailed description is for the purpose of fully disclosing preferred embodiments of the invention without placing limitations thereon.

### BRIEF DESCRIPTION OF THE DRAWINGS

The invention will be more fully understood by reference to the following drawings which are for illustrative purposes only:
FIG. 1 is a schematic representation of a magnetoresistor shunt utilized with a Hall effect sensor according to an aspect of the present invention.
FIG. 2 is a graph of circuit voltages for the circuit according to FIG. 1 in response to angular rotation shown with and without the magnetoresistor shunt.
FIG. 3 is a schematic representation of a magnetoresistor utilized in series with a Hall effect sensor according to an aspect of the present invention.
FIG. 4 is graph comparing circuit voltages for the Hall effect sensor circuit of FIG. 3 showing outputs from three configurations with and without magnetoresistors.
FIG. 5 is a schematic representation of a Hall effect sensor within a Wheatstone bridge of four magnetoresistors according to an aspect of the present invention.
FIG. 6 is a simplified layout for a monolithic circuit whose schematic is shown in FIG. 5.
FIG. 7 is a schematic representation of a dual Hall effect sensor circuit according to an aspect of the present invention.
FIG. 8 is a simplified layout for a monolithic circuit whose schematic is shown in FIG. 7.
FIG. 9 is a schematic representation of magnetoresistors in a bridge configuration according to an aspect of the present invention.
FIG. 10 is a graph of the two sets of resistance characteristics utilized within the magnetoresistors shown in FIG. 9.
FIG. 11 is a graph of circuit voltage in response to magnetic field density for the circuit according to FIG. 9.
FIG. 12 is a cross-section of a two layer integrated magnetoresistor and Hall effect sensor fabricated according to an aspect of the present invention.

### DETAILED DESCRIPTION OF THE INVENTION

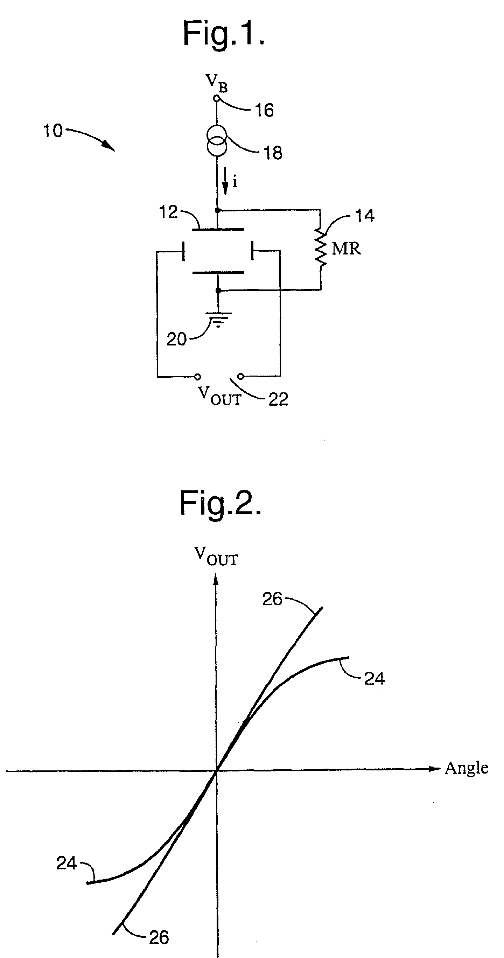

Referring more specifically to the drawings, for illustrative purposes the present invention is embodied in the apparatus generally shown in FIG. 1 through FIG. 12. It will be appreciated that the apparatus may vary as to configuration and as to details of the parts, and that the method may vary as to the specific steps and sequence, without departing from the basic concepts as disclosed herein.

By way of introduction, the present invention tailors the response of a magnetic sensor by using supplemental magnetic sensors chosen with suitable characteristics, and so combined to produce a substantially linear response according to any desired function of magnetic field density B. It should be appreciated that the inventive teachings herein are applicable to a variety of magnetic sensor embodiments in addition to the ones exemplified.

Referring now to FIG. 1, an embodiment of a magnetic sensor circuit 10 in which a Hall effect sensor 12 is configured with a magnetoresistor shunt 14 is shown. A bias voltage V_{B} 16 drives current from a constant current source 18 to the Hall effect sensor 12 which is connected to ground 20. The magnetoresistor 14 is connected across the Hall effect sensor 12 so that the resistance of the magnetoresistor 14 provides a shunt across the Hall effect sensor 12, and circuit output is provided at V_{OUT} 22.

FIG. 2 is a graph of voltage outputs in response to angular position for the circuit of FIG. 1, plotted with and without the use of the magnetoresistor shunt. In measuring angular position, for instance within angle encoder applications, the magnetic field density follows a sinusoidal function. Curve 24 shows the relationship between Hall effect sensor output voltage and angle for an individual Hall effect sensor without a magnetoresistor shunt. The addition of a magnetoresistor shunt 14 to create the circuit of FIG. 1, tailors the response of Hall effect sensor 12 and results in a voltage response depicted by curve 26 in FIG. 2. Subject to low values of field density *B* of either polarity, the magnetoresistor exhibits a relatively low resistance and thereby diverts a substantial portion of the total drive current away from the Hall effect sensor. As the field strength increases the resistance of the magnetoresistor increases more readily than the resistance of the Hall effect sensor, such that less current is diverted thereby boosting the output of the Hall effect sensor accordingly. These offsetting effects in response to the sinusoidal magnetic field density act in concert to straighten the response curve, as can be appreciated from the two comparative plots within FIG. 2. The use of the magnetoresistive shunt 14 coupled with a Hall effect sensor, therefore, provides a significant improvement to the linearization of the Hall effect sensor 12 when resolving a magnetic field that follows a sinusoidal function.

Implementing a magnetoresistor shunt across a Hall effect sensor is a single aspect of the invention, and it should further be appreciated that although the exemplified embodiments employ Hall effect sensors and magnetoresistors, various similar devices can be utilized for tailoring the magnetic field sensors according to the invention. These additional sensor types include, but are not limited to, sensors such as magnetodiodes and magnetotransistors. Furthermore, the magnetic field sensor devices employed may be fabricated from various materials and processes. For example a magnetoresistor can be fabricated from materials which include semiconductors such as InSb, ferromagnetic materials such as permalloy, or from newer materials which provide what has been termed a "giant" or "colossal" magnetoresistive effect.

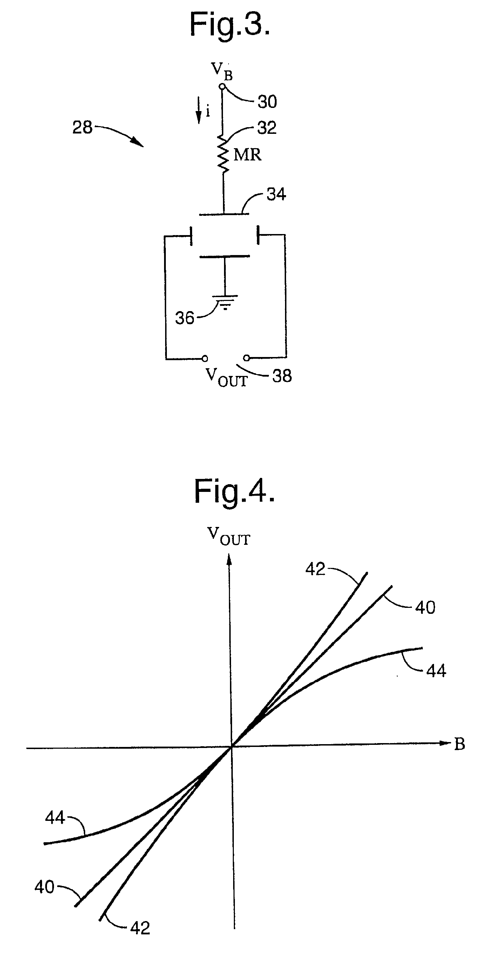

FIG. 3 is a magnetic sensor circuit 28 which provides tailored response characteristics from a Hall effect sensor in series with a magnetoresistor. A bias source V_{B} 30 provides current through a magnetoresistor 32 to a Hall effect sensor 34 toward ground 36. The response of the Hall effect sensor 34 to the applied magnetic field is exibited at V_{OUT} 38. As the magnetic field strength B increases, the series magnetoresistor 32 reduces the series current flowing to the Hall effect sensor 34.

FIG. 4 is a graph of circuit output voltages V_{OUT} generated by three circuit configurations in response to magnetic field density *B*. It should be appreciated that the magnetic function *B* represented in FIG. 4 is a linear function and not that of angular position as depicted in FIG. 2. The linear response 40 of FIG. 4 is that of an individual Hall effect sensor shown to provide a baseline for comparison purposes. Shunting the Hall effect sensor with a magnetoresistor according to the circuit of FIG. 1 yields the response curve 42 of FIG. 4. It can be seen that the addition of the magnetoresistor shunt increases the voltage response of the circuit to the applied magnetic field. Conversely, the addition of the series magnetoresistor, as shown in FIG. 3, yields the flattened response curve 44 of FIG. 4. It will be appreciated that the response 44 produces reduced output voltage levels in response to increasing levels of magnetic field density *B*.

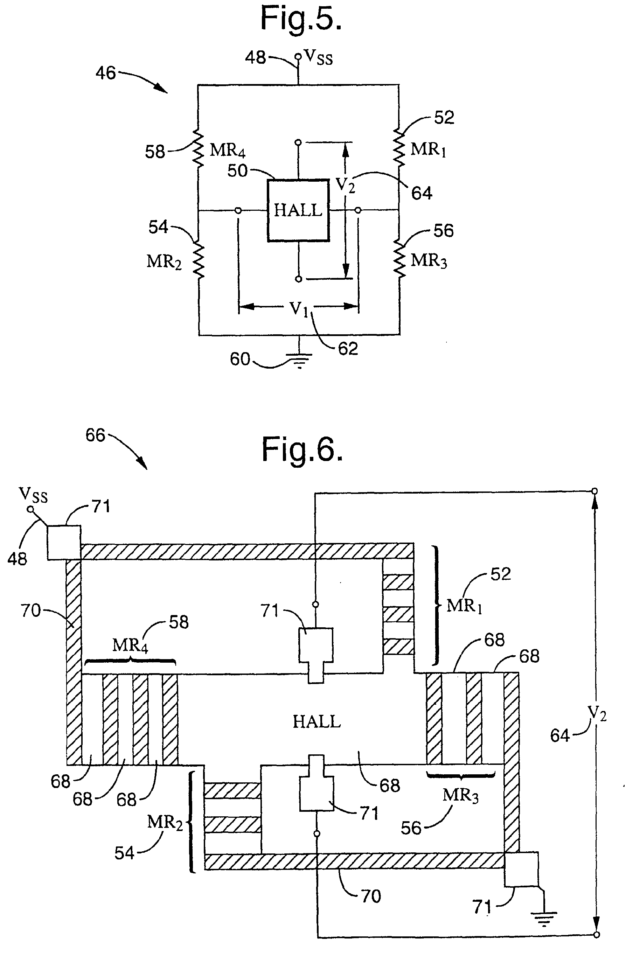

FIG. 5 is a circuit 46 wherein the tailored magnetic response is provided in the form of a Wheatstone bridge. A voltage source Vss 48 provides current to a Hall effect sensor 50 through the voltage differentials provided by four bridge-connected magnetoresistors 52, 54, 56, 58 in reference to ground 60. The output of the Wheatstone bridge is generated at V₂ 64 of the Hall effect sensor. If MR₁ 52 and MR₂ 54 are less sensitive to magnetic field density than MR₃ 56 and MR₄ 58, yet all four magnetoresistor elements exhibit the same temperature dependence, then the circuit can be configured so that the input voltage V₁ 62 to the Hall effect sensor 50 is a quadratic function of the applied magnetic field. The Wheatstone bridge must be unbalanced at a zero field density level where the output voltage is V₁ *(B=0)*. At low magnetic field densities the Hall effect sensor is therefore supplied with a constant voltage, and its output is linear with increasing magnetic field density, homologous to a Hall effect sensor without the added bridging magnetoresistors. At higher field density values where V₁ increases with increasing field density *(B » 0 or B* << *0)*, the voltage output of the Hall effect sensor increases rapidly in comparison with a linear output. The Wheatstone bridge circuit for a magnetic sensor with a tailored response is well suited for linearizing the output of angular position sensors, in which the magnetic circuit would produce a biasing field *B = sin(θ)* where θ is the angle to be measured. The output of a simple linear Hall sensor within the circuit of FIG. 5 is given by *V*_{*HALL*} *= αB + βB*^{*2*}. Through the proper adjustment of the values for MR₁, MR₂, MR₃, and MR₄ the circuit can be configured to yield a response which resembles *V*₂ = α *arcsin(B)* = αθ. This configuration of circuitry is well suited to linearizing angular measurements such as found in angular position sensor applications.

Packaging a magnetic sensor with tailored response according to the present invention is preferably accomplished by fabricating a single substrate utilizing a single set of processing techniques to produce low cost integrated circuit die. Furthermore, it should be recognized that a number of magnetic field sensors and integrated processing functions may be included within the integrated circuit. FIG. 6 exemplifies an embodiment of integrated circuit geometry utilizing deposited InSb films on a monolithic substrate 66 to implement the circuit shown in FIG. 5. The substrate 66, preferably Gallium Arsenide (GaAs), contains magnetoresistive areas 68 and conductive areas 70 which include bonding pads 71. The magnetoresistive areas 68 are preferably implemented by depositing Indium Antimony (InSb) onto the substrate 66 and the conductive areas 70, 71 are preferably created from depositing Gold (Au) onto the substrate 66.

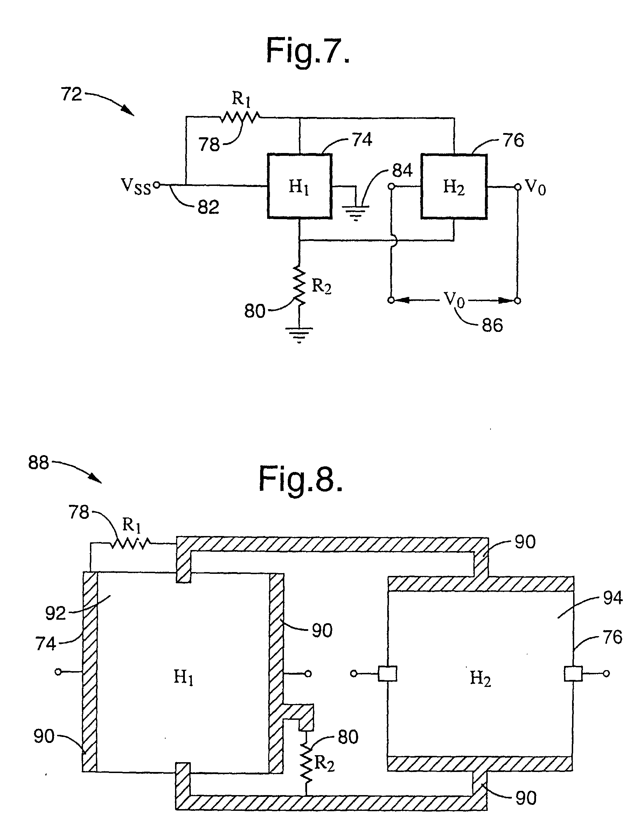

FIG. 7 is a sensor circuit 72 which provides a tailored output from two Hall effect sensors 74, 76 whose output is tailored to yield a quadratic output in response to a magnetic field. The sensor circuit can provide a tailored response without the shunting resistors R₁ 78 and R₂ 80, wherein the Hall effect sensor H₁ 74 has an output that serves as an input to the second Hall effect sensor H₂ 76. The Hall effect sensors need not have identical characteristics and it should be recognized that through utilizing sensors with differing characteristics, a wide variety of magnetic field functions may be supported. The shunting resistors R₁ 78 and R₂ 80, partially shunt H₁ 74 and thereby add a linear term to the resultant response that can boost the sensitivity of the circuit to low amplitude magnetic fields. It will be appreciated that the use of magnetoresistors in place of the resistors R₁ 78 and R₂ 80, would not provide a linear term and instead would provide a quadratic response to the magnetic field far in excess of what would otherwise be produced. FIG. 8 exemplifies a monolithic implementation 88 of the "nested" magnetic sensor circuit of FIG. 7. Conductive areas 90 are deposited on the substrate over Indium Antimony (InSb) or the like. Two different deposition thicknesses for the Indium Antimony (InSb) are reflected in area 92 of sensor H₁ 74, and area 94 of sensor H₂ 76.

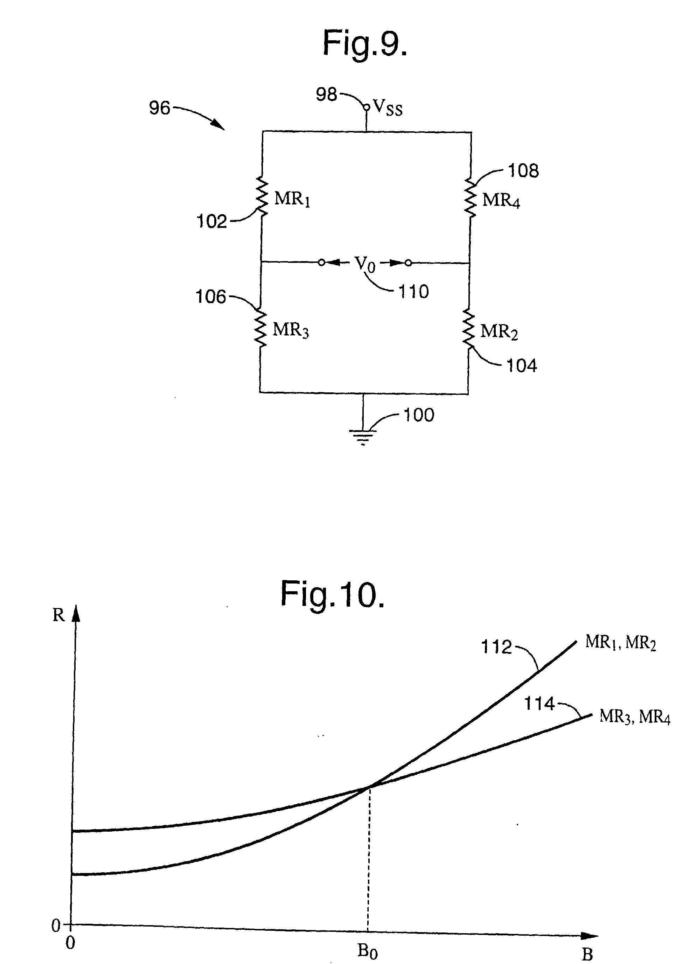

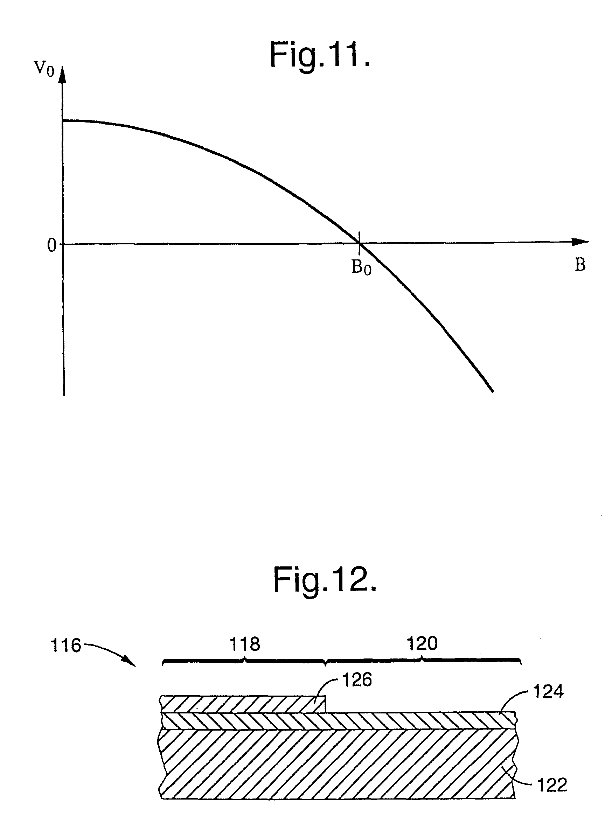

A bridging arrangement of magnetic sensors was described in reference to FIG. 5 which included a Hall effect sensor; however, a tailored response magnetic circuit can be implemented in various bridge arrangements. FIG. 9 illustrates an example of a Wheatstone bridge arrangement 96 connected between Vₛₛ 98 and ground 100 that does not require a Hall effect sensor. The Wheatstone bridge circuit comprises four magnetoresistors whose relative device characteristics determine the tailored magnetic response. Exemplifying the relative device characteristics, consider that the individual magnetoresistor elements MR₁ 102 and MR₂ 104 provide different responses as a function of magnetic field density than do the magnetoresistor elements MR₃ 106 and MR₄ 108. FIG. 10 depicts response disparity as characteristic graphs of resistance *R* as a function of magnetic field density *B,* in which the characteristics of the magnetoresistors for both MR₁ and MR₂ are shown by the curve 112, which indicates an increased response to magnetic field density in relation to the curve 114 for magnetoresistors MR₃ and MR₄ 114. FIG. 11 illustrates the response of the Wheatstone bridge embodiment of FIG. 9 whose tailored response provides a voltage output which is a decreasing function of magnetic field density. The output illustrated in FIG.11 changes polarity at *B = B*_{*0*}, the location of *B*_{*0*} being dependent on the relative characteristics of MR₁, MR₂, MR₃, and MR₄. It should, therefore, be appreciated that the shapes of the curves, as shown in FIG. 10 and FIG. 11, and the cross-over points therein can be altered through magnetoresistor selection to suit specific magnetic field density functions.

As can be seen, therefore, various embodiments of magnetic sensors which provide a tailored magnetic response to a function of magnetic field density according to the invention have been described in these configurations:
- H - M: combination of Hall sensors and magnetoresistors
- H - H: combination of two or more Hall effect sensors which may have different response curves
- M - M: combining two or more magnetoresistors which have different response curves.
Other circuit arrangements and sensor varieties responsive to magnetic field density may be utilized, as described previously, to produce circuits which provide any number of tailored response characteristics.

The magnetic field sensing circuits according to the invention can in general be fabricated from discrete devices or integrated to a greater or lesser extent. In the case of MRs, they are typically made from narrow energy gap semiconductors with small electron effective masses, such as lnSb or lnAs. While MRs can be made from these materials in bulk crystal form, it is generally preferable to deposit these materials as thin films on an electrically insulating substrate, which may be a single crystal semiconductor such as Si, GaAs, or InP, or it may be a glass or ceramic material. Deposition onto a glass or ceramic substrate, often followed by a thermal annealing step, generally results in polycrystalline material with properties which are sufficient for a number of applications. If properly performed, deposition onto a single crystal produces single crystal (epitaxial) thin films which provide relatively high levels of crystallinity and high electron mobilities, as required for the fabrication of high sensitivity magnetoresistors. The properties of MRs are determined largely by the following factors which are generally recognized within the industry: geometry, film composition, thickness, surface preparation, doping, crystal growth conditions, composition variations with thickness, and particulars relating to the type and crystallographic orientation of the substrate. For example, the thin film is typically etched into a long mesa pattern which is then periodically covered with metal "shorting bars". The length-to-width ratio of each MR element between the shorting bars, and the number of such elements that are put in series, are both important factors affecting the magnetic sensitivity of the MR element. Numerous alternative geometries can additionally be applied, such as a Corbino disk, which will be recognized by those of ordinary skill in the art.

In several cases described above, at least two devices selected from the categories of Hall effect sensors and MRs are utilized in combination within a circuit. The benefits of integrating a large portion of the circuit on a single substrate will be appreciated, as this results in lower costs, increased reliability, and reduced size. It will be further appreciated that depositing an identical thin film on the substrate for the production of both MR elements and Hall effect sensors results in a simplified fabrication procedure. However, it is frequently the situation that a given film which is optimal for creating MRs is not optimal for creating Hall effect sensors. In particular, fabrication of an MR element requires deposition of a relatively thick film in comparison with fabrication of a Hall effect sensor. The disparity in optimum thickness is due largely to the requirement of an MR element for very high electron mobility in order for it to exhibit adequate sensitivity. If lower carrier mobility material is deposited when fabricating Hall effect sensors and MR sensors, the Hall effect sensors exhibit a slight reduction of sensitivity, while the MR sensors, fabricated from the same deposited film, exhibit a substantial sensitivity reduction. Doping further complicates fabrication, as one may dope the thin film toward being a substantially n-type material so as to decrease the dependence of electron density on temperature. Doping of the films, however, leads to a reduction in the sheet resistance of the deposited film and the Hall effect sensors so produced have a low input resistance, on the order of approximately 10 ohms to approximately 100 ohms, which is reflected as a relatively large power dissipation for any given bias voltage. It may be advisable, therefore, to reduce the film thickness when fabricating a Hall effect sensor and numerous methods exist for providing this reduction. One such method involves etching away a portion, or layer, of film to reduce the thickness in the region of the fabricated Hall effect sensor. Etching can reduce the mobility of the remaining current carriers, although, it is still capable of providing acceptable results for many applications. The desirability of having a choice of serviceable methods for thinning the depositions should be appreciated in view of the difficulties often encountered in controlling etch depth within a homogeneous film.

A measure of control over the etching process can be gained by depositing the film in layers of differing composition, such as InSb over GaSb. FIG. 12 shows a partial cross-section view of a monolithic circuit 116, having a region 118 upon which a magnetoresistor is fabricated, and a region 120 upon which a Hall effect sensor is fabricated. A substrate 122, preferably GaAs, is shown covered by an n-type GaSb first layer 124 and an n-type InSb second layer 126. The second layer was etched away in the region of the Hall effect sensor which substantially increases the sheet resistance in that region. In this example, the GaSb first layer 124 may be doped n-type, doped p-type, or nominally undoped, since that generally produces p-type material because of native defects in GaSb. The lnSb second layer 126 layer requires an appreciable density of electrons to create a sensitive MR, since the electrons have a significantly larger mobility than holes within the material. Therefore, at least a part of the deposited thickness preferably comprises n-type, or alternately undoped, material. Undoped material may be utilized within some applications as the intrinsic electron density in lnSb is often sufficient if the minimum device operating temperature is not excessively low. The InSb second layer 126 may comprise a more complex structure including a GaSb buffer layer (not shown). In addition, or alternatively, a buffer layer may be used whose lattice structure approximates that of lnSb involving ln₁₋ₓAlₓSb, ln₁₋ₓGaₓSb or lnPₓSb₁₋ₓ, and would preferably be followed by an lnSb layer whose doping levels are frequently varied during growth of the layer.

Deposition layer options are discussed in an article by D. L. Partin et al. within Sensors and Actuators, volume 69, pages 39-45, 1998; along with U.S. Patent No. 5,883,564 to Partin; and U.S. Patent Nos. 5,184,106 and 5,153,557, both by Partin and Heremans. Each of the foregoing patents and publications are incorporated herein by reference.

It should be appreciated that other materials, such as alloys of lnSb or InAs, along with additional doping variations during growth can provide advantages when fabricating material for magnetoresistor sensors.

Alternative approaches can be utilized to provide the effect of a deposited first layer. Considering the layers shown in FIG. 12, the first layer 124 may be alternatively created on the substrate 122, by implanting or diffusing a thin surface layer of the substrate with dopants to convert it to n-type or p-type conductivity. Conversion can be performed by conventional ion implantation of a dopant impurity followed by thermal annealing, or by dopant diffusion. Thus, in the case of a GaAs insulating substrate, a donor impurity such as Si can be ion implanted and annealed. As the doped regions constitute a first layer, a second layer 126 may then be deposited thereon. It should be recognized that, alternatively, the first layer may be formed by deposition of an n-type or p-type epitaxial GaAs layer followed by the deposition of a second layer. In considering additional variations, the first or second layer may themselves comprise a number of layers in order to optimize material properties, while the addition of a third, and possibly subsequent layers are considered. Such layering is especially beneficial when MRs or Hall effect sensors are to be fabricated having two or more differing thicknesses in order to provide material property variation.

Alternative materials may also be utilized, for example, the first layer 124 of FIG. 12 may comprise a layer of lnP, lnAs, lnSb, GaAs, or an alloy thereof, such as ln₁₋ₓAlₓSb; while the second layer 126 may comprise a layer of lnAs, lnSb, or an alloy of Sb, lnSb, or lnAs.

Furthermore, the properties of an MR or Hall effect sensor can be varied, even if they are fabricated from the identical unaltered epitaxial film, by varying the processing geometry. For example, if an MR is fabricated from an extended mesa with metal shorting bars deposited periodically along its length, then the properties of the MR are dependant upon both the width of the mesas and the spacing between the shorting bars.

The materials mentioned in connection with FIG. 12 are provided by way of example and not of limitation. Thereby, materials utilized in connection with one description, such as those mentioned and those which would be obvious to one of ordinary skill in the art, may in general be utilized with the other descriptions and obvious variations thereof.

Accordingly, it will be seen that this invention provides tailored responses from magnetic sensor circuits and can be implemented with numerous variations based on the aforesaid descriptions, and variations which are obvious to one of ordinary skill in the art.

Although the description above contains many specificities, these should not be construed as limiting the scope of the invention but as merely providing illustrations of some of the presently preferred embodiments of this invention. Thus the scope of this invention should be determined by the appended claims and their legal equivalents. Therefore, it will be appreciated that the scope of the present invention fully encompasses other embodiments which may become obvious to those skilled in the art, and that the scope of the present invention is accordingly to be limited by nothing other than the appended claims, in which reference to an element in the singular is not intended to mean "one and only one" unless explicitly so stated, but rather "one or more." All structural, chemical, and functional equivalents to the elements of the above-described preferred embodiment that are known to those of ordinary skill in the art are expressly incorporated herein by reference and are intended to be encompassed by the present claims. Moreover, it is not necessary for a device or method to address each and every problem sought to be solved by the present invention, for it to be encompassed by the present claims. Furthermore, no element, component, or method step in the present disclosure is intended to be dedicated to the public regardless of whether the element, component, or method step is explicitly recited in the claims. No claim element herein is to be construed under the provisions of 35 U.S.C. 112, sixth paragraph, unless the element is expressly recited using the phrase "means for."

## Claims

1. A magnetic field sensing circuit (10) with tailored magnetic response, comprising:
(a) a first magnetic field sensing device (12); and
(b) a second magnetic field sensing device (14) operatively coupled to said first device and configured for adjusting the output response of said first device to magnetic field density according to a predetermined function of the magnetic field density.

2. In a circuit having a first magnetic field sensor (12) which generates an output signal in response to magnetic field density, the improvement comprising:
at least one additional magnetic field sensor (14) responsive to magnetic field density which is in electrical connection with said first magnetic field sensor (12) and configured to adjust the output response of the first sensor (12) according to a predetermined function of the magnetic field density.

3. A circuit for generating an output signal in response to a predetermined function of the magnetic field density, comprising:
(a) a first magnetic field sensor (12) responsive to magnetic field density; and
(b) at least one additional magnetic field sensor (14) responsive to magnetic field density which is in electrical connection with said first magnetic field sensor (12), said combination of sensors providing a tailored output response of said circuit.

4. A circuit as recited in claim 3, wherein said circuit is implemented monolithically and wherein said sensors are fabricated on a single substrate.

5. A circuit as recited in claim 4, wherein the monolithic circuit is implemented in thin film.

6. A circuit as recited in claim 3, wherein the additional magnetic field sensor (14) is operably connected in series to the first magnetic field sensor (12).

7. A circuit as recited in claim 3, wherein the additional magnetic field sensor (14) is operably connected to shunt the first magnetic field sensor (12).

8. A circuit as recited in claim 3, wherein said sensors are connected in a bridge circuit configuration (96).

9. A circuit as recited in claim 8, wherein the bridge circuit (96) comprises a Wheatstone bridge (46).

10. A circuit as recited in claim 3, wherein said sensors comprise Hall effect sensors.

11. A circuit as recited in claim 3, wherein said sensors comprise magnetoresistive elements.

12. A circuit as recited in claim 3, wherein said first sensor comprises a Hall effect sensor, and wherein at least one said additional magnetic field sensor comprises a magnetoresistive device.

13. A circuit as recited in claim 12, wherein the Hall effect sensor and magnetoresistive device are fabricated on the same substrate (66).

14. A circuit as recited in claim 13, wherein film is deposited onto the substrate (66) for the Hall effect sensor and the magnetoresistive device.

15. A circuit as recited in claim 14, wherein the deposited film geometry for the Hall effect sensor and the magnetoresistive device areas are altered to compensate for singular characteristics of the deposited material.

16. A circuit as recited in claim 15, wherein the deposited film is thinned in the area of the Hall effect sensor (120) to improve device characteristics.

17. A circuit as recited in claim 16, wherein the thinning of the film for the Hall effect sensor (120) is controlled by depositing the film in two layers, a first layer of a first composition and a second layer of a second composition such that both layers in combination are used for magnetoresistive devices and the second layer is etched away from the first layer to fabricate Hall effect sensors.

18. A circuit as recited in claim 16, wherein a first layer is produced by implanting ions to selectively change the conductivity of the substrate followed by depositing of thin film to form a second layer.

19. A circuit as recited in claim 14, wherein a first layer is produced by depositing a thin film layer, and a second layer is produced by implanting or diffusing ions to selectively change the conductivity of the deposited layer.

20. A circuit as recited in claim 14, further comprising additional layers of differing material composition which are added to improve device characteristics.

21. A method of tailoring the response of a circuit containing a first magnetic field sensor (12) to a predetermined function of magnetic field density, comprising:
connecting an additional magnetic field sensor (14) in the circuit to alter the response characteristics of said first magnetic field sensor according to the predetermined function.

22. A method as recited in claim 21, wherein the additional magnetic field sensor (14) is connected to said first magnetic field sensor (12) as a parallel circuit element.

23. A method as recited in claim 21, wherein the additional magnetic field sensor (14) is connected to said first magnetic field sensor (12) as a series circuit element.

24. A method as recited in claim 19, wherein the additional magnetic field sensors (14) are connected to said first magnetic field sensor (12) to form a bridge circuit (46, 96).
